Europäisches Patentamt

European Patent Office

Office européen des brevets

(11) Publication number: **0 155 512 B1**

(12) **EUROPEAN PATENT SPECIFICATION**

(45) Date of publication of patent specification: **30.09.92**  (51) Int. Cl.⁵: **H05K 13/04**

(21) Application number: **85101747.5**

(22) Date of filing: **16.02.85**

(54) **Automatic apparatus for mounting electronic parts.**

(30) Priority: **17.02.84 JP 28911/84**

(43) Date of publication of application:
**25.09.85 Bulletin 85/39**

(45) Publication of the grant of the patent:
**30.09.92 Bulletin 92/40**

(84) Designated Contracting States:
**DE FR GB**

(56) References cited:
**GB-A- 2 108 015**

(73) Proprietor: **MATSUSHITA ELECTRIC INDUSTRI-
AL CO., LTD.**
**1006, Oaza Kadoma**
**Kadoma-shi, Osaka-fu, 571(JP)**

(72) Inventor: **Fujita, Takayuki**
**6-6, Ikagasakaemachi**
**Hirakata-shi Osaka-fu(JP)**
Inventor: **Negishi, Shigetoshi**
**5-112, 41, Yamadahigashi 4-chome**
**Suita- shi Osaka-fu(JP)**
Inventor: **Tanaka, Kunio**
**20-3, Miyamae-cho**
**Kadoma-shi Osaka-fu(JP)**

(74) Representative: **Eisenführ, Speiser & Partner**
**Martinistrasse 24**
**W-2800 Bremen 1(DE)**

Rank Xerox (UK) Business Services

EP 0 155 512 B1

## Description

## BACKGROUND OF THE INVENTION

### Field of the Invention

The present invention relates to an automatic apparatus for mounting electronic parts, which engages electronic parts of chip type on a print circuit board constituting the circuit portion of electronic devices.

### Description of the Prior Art

Conventionally various chip parts 1a through 1d shown in Figs. 1(A) through 1(D) are supplied to a user in a form of a tape shape, wrapped with adhesive tape 4 and ground paper 3 having many accommodation concave portions 2 formed therein continuously at equal distances as shown in Fig. 2. To mount the electronic parts of the tape shape on the print circuit board, such an automatic apparatus for mounting electronic parts of a single head type as shown in Fig. 3 is generally employed and put on the city market.

In the automatic apparatus for mounting electronic parts shown in Fig. 3, a plurality of parts cassettes 5, each having various electronic parts provided on a casing 10, are adapted to be movable in a direction Z so that mounting parts may be selected at a certain position. The apparatus is operated in that a mounting chuck 6 absorbs an electronic parts positioned in its adsorption position, and a positioning pawl 7 picks it up for the positioning operation. Also, the mounting chuck 6 mounts the electronic parts on the print circuit board 9 positioned by an X-Y table 8 which is movable in two directions X and Y. However, in this mechanism, the mounting chuck 6 absorbs the electronic parts and the positioning pawl 7 positions it for the mounting operation, thus resulting in complicated operations. The mounting chuck 6 reciprocates over the parts cassette 5 and the X-Y table 8 to mount the parts on the print circuit board 9 and thereafter returns to absorb the next electronic parts, thus resulting in low mounting speed. Furthermore, one mounting chuck 6 cannot handle the electronic parts in accordance with their size and type. Accordingly, an automatic apparatus for mounting electronic parts for exclusive use are rendered necessary in accordance with their sizes and types of the electronic parts.

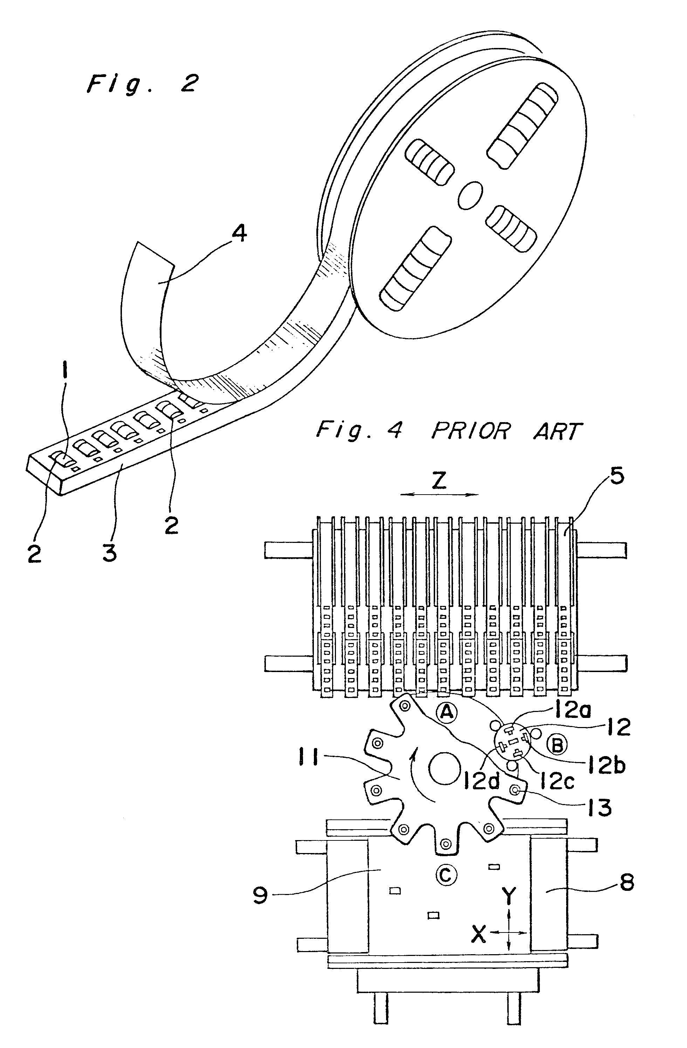

Fig. 4 shows a top-face view of an automatic apparatus for mounting electronic parts of a turntable type, which is improved in the mounting speed. In this automatic apparatus for mounting electronic parts, a plurality of parts cassettes 5 are adapted to be movable in the direction of Z, as in the mounting apparatus of Fig. 3, for the choice of the mounting parts. The electronic parts are absorbed by a positioning and mounting unit 12 in the position of (A) and thereafter a turntable 11 rotates. In the position of (B), the positioning and mounting unit 12 absorbing electronic parts by its pawls 12a through 12d determines the position and the mounting direction of the electronic parts, and, in the position of (C), the mounting chuck 13 is adapted to fall the electronic parts on the print circuit board 9 on the X-Y table 8 to perform the mounting operation. According to this arrangement, each operation is simplified, the operation distance can be shortened, the turntable 11 is rotated, indexing in one direction, so that this apparatus has a faster mounting speed than the apparatus of Fig. 3. However, as the mounting chuck 13 is of one type, various kinds of electronic parts cannot be mounted because of changes in the size and type. Thus, an automatic apparatus for mounting electronic parts for exclusive use is required in accordance with the type of each electronic parts.

An apparatus for mounting chip type circuit elements according to the preamble of claim 1 is disclosed in GB-A-2 108 015, where the mechanical gripping type handling construction, in which the mounting head is provided with a sucking pin positioned intermediate between two gripping members, permits a larger tolerance of the size of the chip type circuit elements, which in turn enables the apparatus to handle a large variety of chip type circuit elements.

## SUMMARY OF THE INVENTION

Accordingly, an object of the present invention is to provide an automatic apparatus for mounting electronic parts, wherein mounting chucks of units can be fitted to the various shapes of the electronic parts with high reliability and superior efficiency.

Another object of the present invention is to provide an automatic apparatus for mounting electronic parts, where the mounting chucks are adapted to allow the vertical movement only with providing the positioning operation for electronic parts made during the holding and mounting operation thereof made in a direction during the indexing operation, so that both operations can be divided, the mounting speed can be improved and the mounting of electronic parts is performed with high productivity.

A further object of the present invention is to provide an automatic apparatus for mounting electronic parts, wherein in the mounting heads the mounting chuck is pivotably selected so that the absorbing, positioning and mounting operations of the mounting chuck may be performed at one location as one positioning unit and the parts cassettes are provided as unit, whereby the electronic-parts feeding, ground-paper tape delivering and adhesive-tape tearing off operations can be easily performed.

According to the present invention, there is provided an automatic apparatus for mounting various kinds of electronic parts, comprising an X-Y table for positioning a printed circuit board, a plurality of parts cassettes disposed near the X-Y table, a turntable, a plurality of mounting heads mounted in positions divided into equal intervals on the turntable, a plurality of mounting chucks disposed on each of said mounting heads and being different in shape, fitted to the shape of the electronic parts, cams disposed on the periphery of said turntable, one of said cams being adapted to select one mounting chuck provided on each of the mounting heads, while the selected mounting chuck picks up electronic parts from the parts cassettes, adapted to move in the lateral direction, to mount said electronic parts on the printed circuit board, so that electronic parts different in shape can be mounted on the substrate with a faster mounting speed.

## BRIEF DESCRIPTION OF THE DRAWINGS

These and other objects and features of the present invention will become apparent from the following description taken in conjunction with the preferred embodiments thereof with reference to the accompanying drawings, in which:

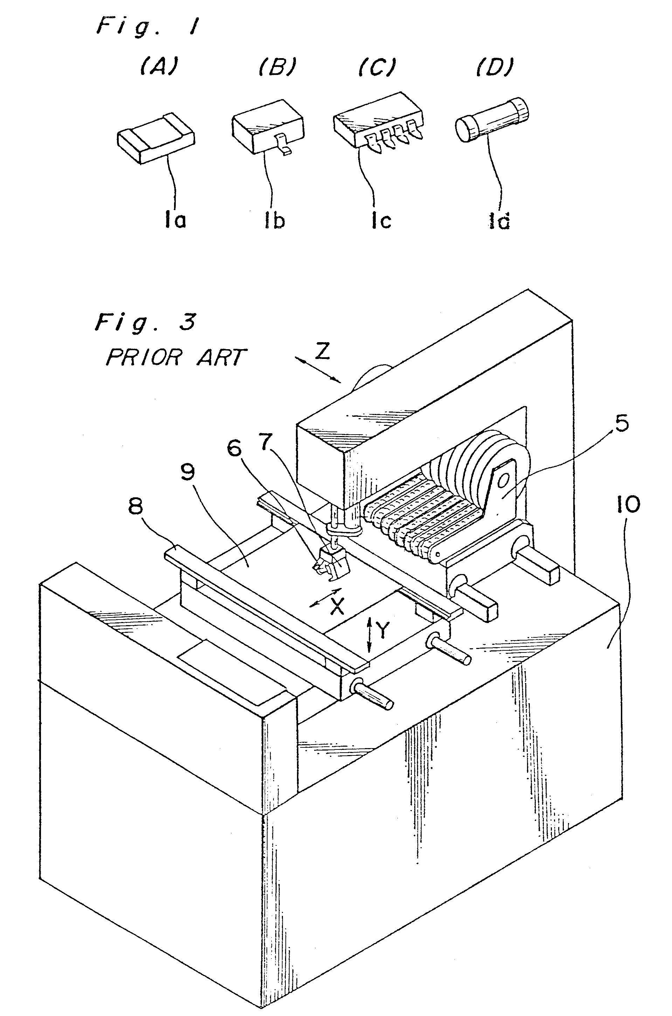

Figs. 1(A) through 1(D) are perspective views showing electronic parts of a chip type;

Fig. 2 is a perspective view showing the tape shape of the chip type of electronic parts;

Fig. 3 is a perspective view showing a conventional automatic apparatus for mounting electronic parts of a single head type (already referred to);

Fig. 4 is a plane layout view of a conventional automatic apparatus for mounting electronic parts of a turntable type (already referred to);

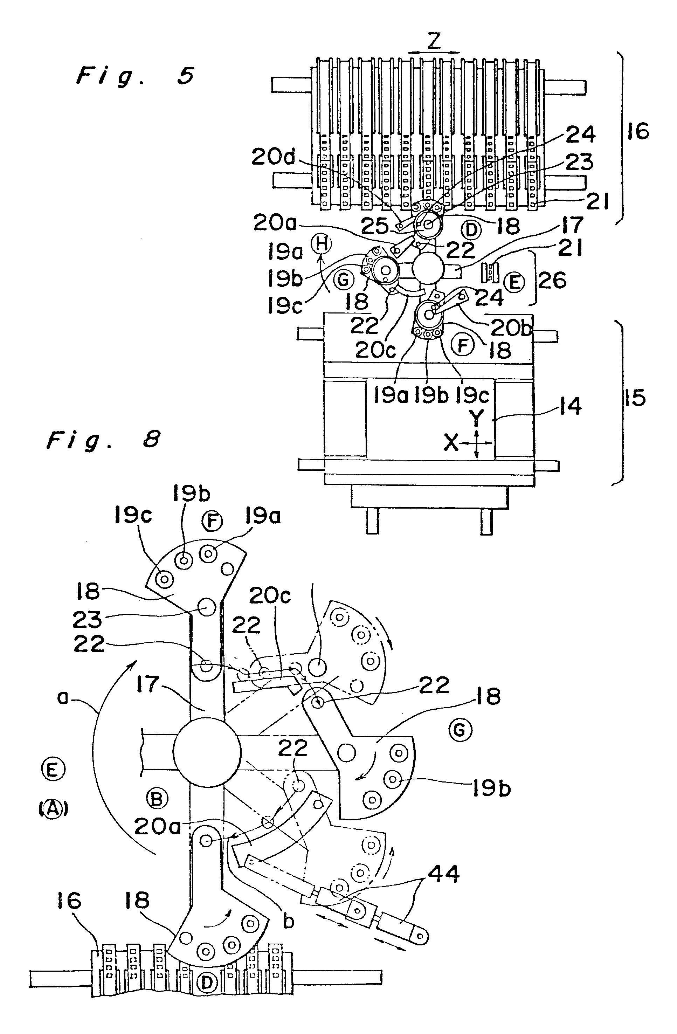

Fig. 5 is a plane layout view for describing the fundamental construction of an automatic apparatus for mounting electronic parts of the present invention;

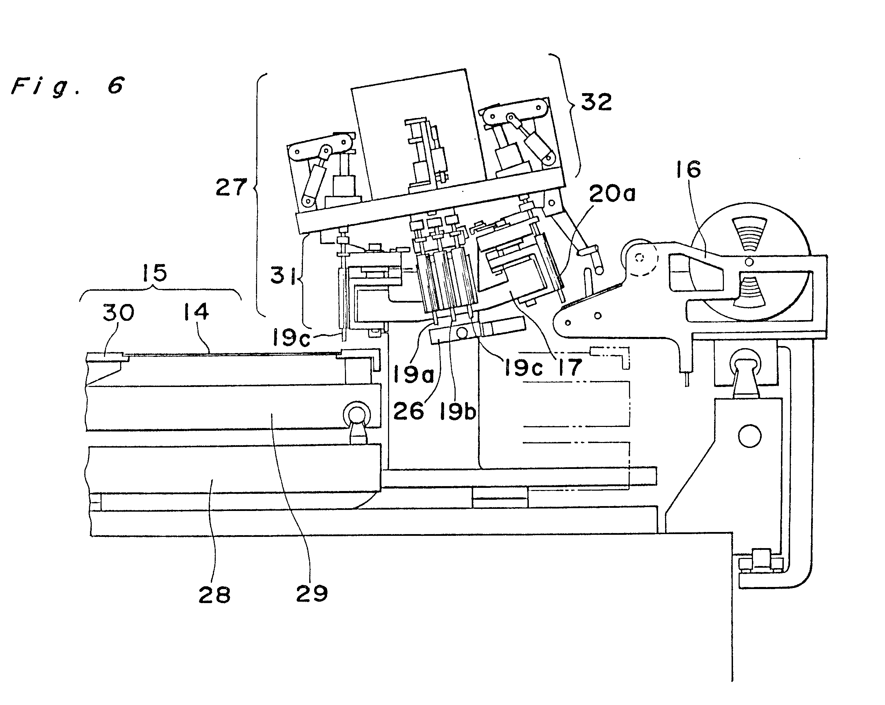

Fig. 6 is a plane view of the apparatus;

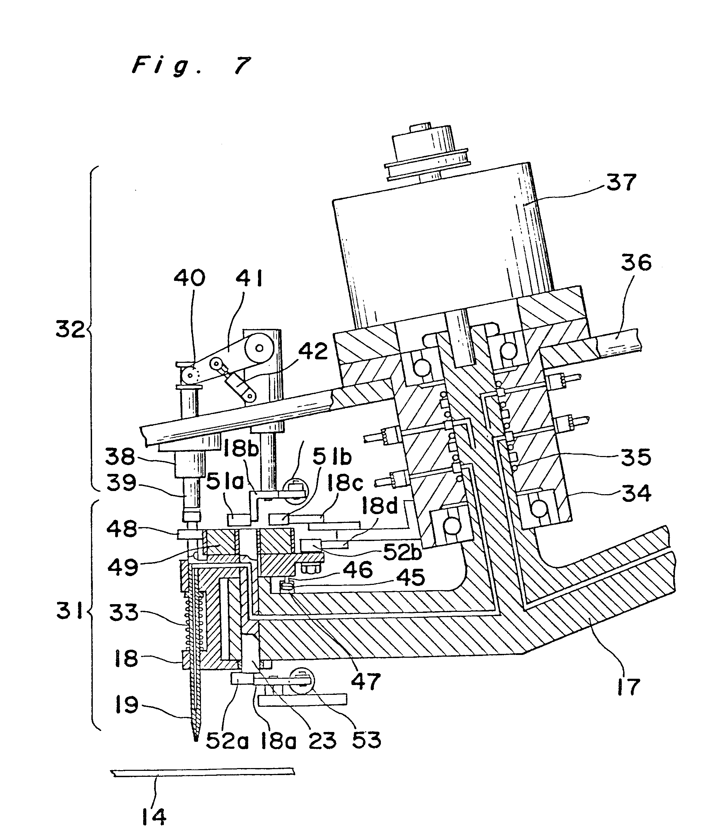

Fig. 7 is an enlarged cross-sectional view of essential portions of the apparatus;

Fig. 8 is a plane layout view of a mounting chuck selecting mechanism for the apparatus;

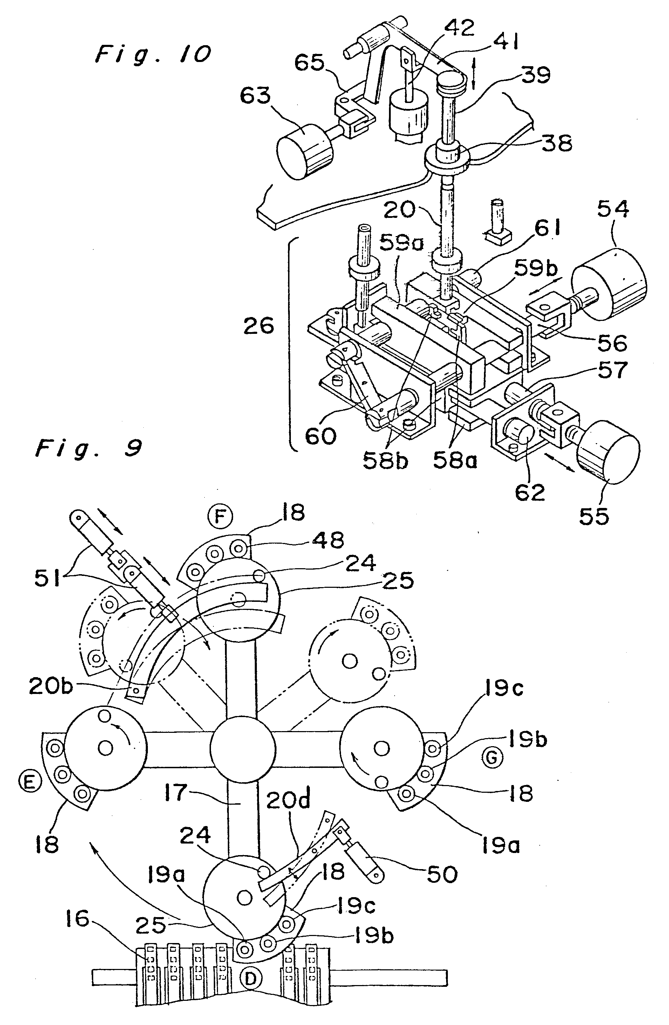

Fig. 9 is a plane layout view of a mounting direction mechanism of the apparatus;

Fig. 10 is an essential portion perspective view showing a position controlling mechanism of the apparatus;

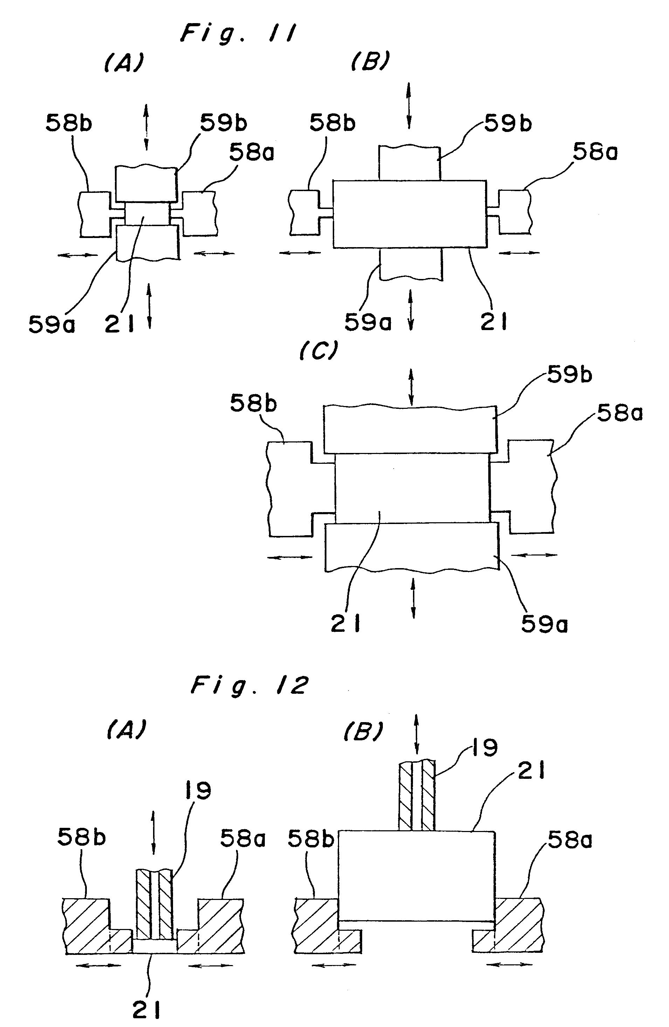

Figs. 11(A) through 11(C) and Figs. 12(A) and 12(B) are plane layout views, each showing the mounting operation of the apparatus, respectively; and

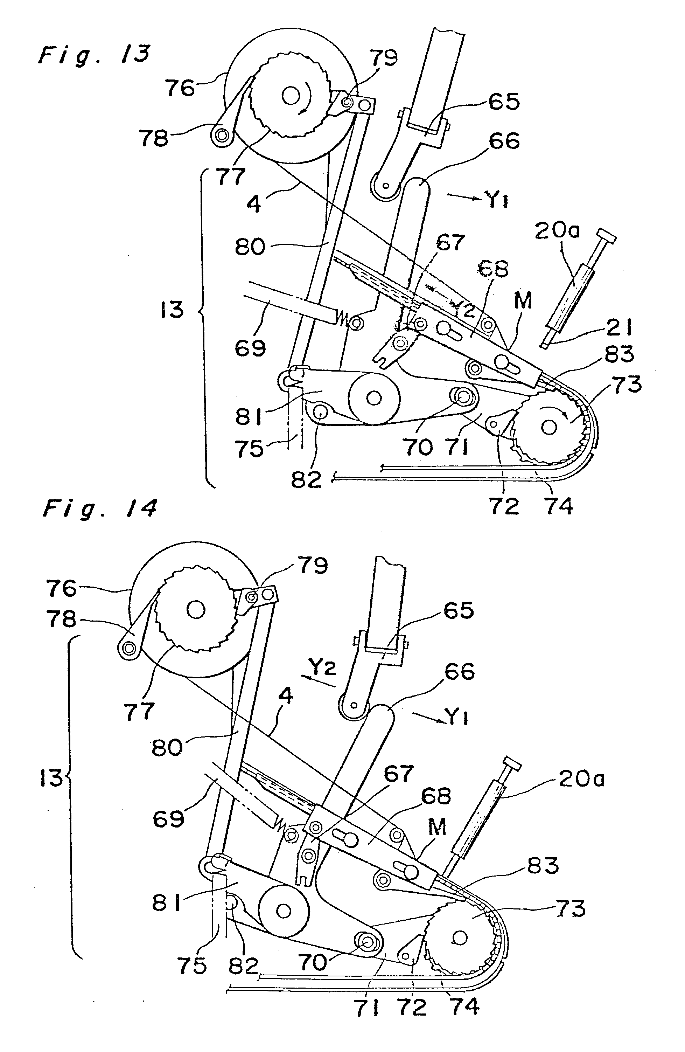

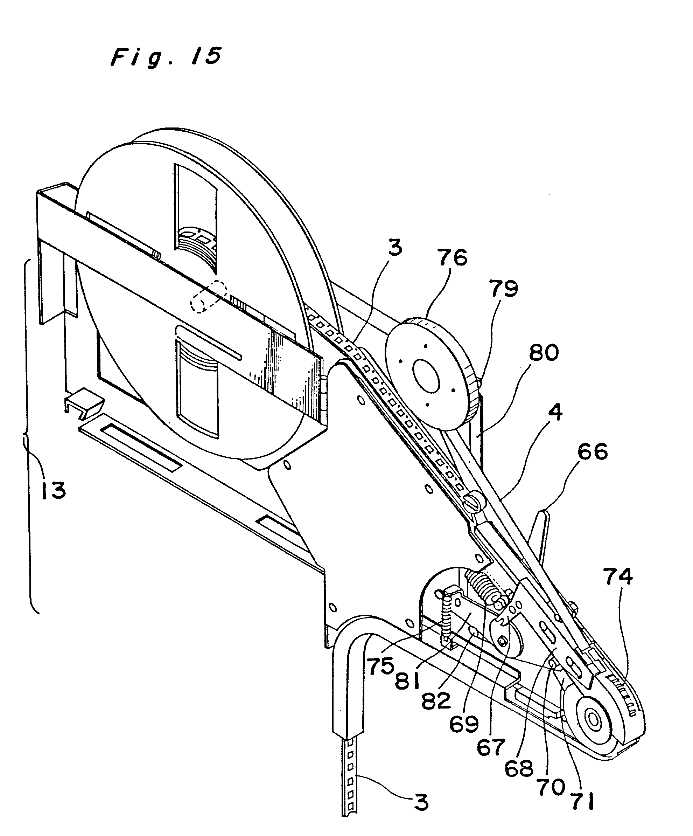

Fig. 13 through Fig. 15 are views, each showing the parts cassettes of the apparatus.

## DESCRIPTION OF THE PREFERRED EMBODIMENTS

The fundamental construction of an automatic apparatus for mounting electronic parts in accordance with the present invention as shown in Fig. 5 will be described hereinafter at first. Referring to Fig. 5, the automatic apparatus for mounting electronic parts comprises, in principle, an X-Y table 15 for moving a print substrate or print circuit board 14 in the directions of arrows X and Y for the positioning operation, parts cassettes 16 provided near the X-Y table 15 and movable in the direction of an arrow Z, which is the same direction as the direction of an arrow X, and a positioning unit 26, including a turntable 17 disposed between the X-Y table 15 and the parts cassettes 16 and adapted to perform an indexing operation, rotating in the direction of an arrow (H), a mounting head 18 mounted respectively at four locations of the turntable 17 and adapted to be pivotable, a plurality of types of liftable and rotatable mounting chucks 19a through 19c disposed, describing a circular arc, on the outer periphery of the mounting head 18, a plate-shaped mounting chuck selection cam 20a disposed above the turntable 17, a mounting direction selection cam 20b, an origin return cam 20c and a polarity selection cam 20d. As the turntable 17 moves, the mounting head 18 oscillates through a supporting point 23 among each position of (G), (D), (E) and (F), with the motion of a cam follower 22 by a cam 20a which is driven in accordance with data determining the type of an electronic parts 21 to be mounted, and the mounting head selects one of the mounting chucks 19a through 19c. For example, one mounting chuck 19b selected operates to absorb an electronic parts 21 to be mounted in the position of the (D), at the same time a polarity selection cam 20d moves a cam follower 24 to rotate a gear 25 through the supporting shaft 23 to determine the direction of the mounting chuck 19b. Thus, the mounting chuck 19b is rotated by 180° when necessary. The positioning unit 26 grasps an electronic parts 21 in the position of (E) to perform the positioning operation. A cam follower 24 is rotated through a supporting point 23 by a mounting direction selection cam 20b, which is driven in accordance with data determining the type of the same electronic parts 21, as described hereinabove, among the indexings to the following (E) through (F) positions, to determine the mounting direction of the mounting chuck 19b and is rotated by 90° when necessary. In the position of (F), the mounting chuck 19b falls to complete the engagement of the electronic parts 21 on print circuit board 14 with bonding agent printed thereon. An origin return cam 20c is used in the origin return of the selection of the mounting chucks 19a through 19c, while a polarity selection cam 20d is used in each origin return of the mounting direction.

As described hereinabove, in the present embodiment, a mounting chuck 19 coincided with the shape, even if the shape of the electronic parts 21 is different, can be selected by a mounting chuck selection cam 20a during the rotation of the turntable 17. Accordingly, in the present embodiment, many types of electronic parts can be mounted on the substrate with a faster mounting speed.

Also, in the present embodiment, the polarity selection cam 20d and the mounting direction cam 20b determine the mounting direction of an electronic parts 21 during the rotation of the turntable 17. Accordingly, in the present embodiment, a faster mounting speed can be provided even in this point.

In the present embodiment, the electronic parts 21 selected by the polarity selection cam 20a is rotated by 0° or 180°, and thereafter is positioned by a positioning unit 26. Then, it is rotated by 0° or 90° in the position of (F) by a mounting direction selection cam 20b. in this manner, the electronic parts 21 is taken out of the parts cassette 16 and thereafter the mounting directions can be varied in four directions of 0°, 90°, 180° or 270° to perform a faster speed mounting operation on the print circuit board 14. Also, in the present embodiment, the mounting direction is divided into two by cams 20b and 20d and is determined. Thus, the electronic parts 21 to be positioned by a positioning unit 26 is 0° or 180° to simplify the construction of the positioning unit 26.

A concrete embodiment of an automatic apparatus for mounting electronic parts in accordance with the present invention will be described hereinafter with reference to Fig. 6 through Fig. 15, in which the same reference characters are given to the same parts.

As shown in the side view of Fig. 6, the automatic apparatus for mounting electronic parts of the present invention is chiefly composed of an X-Y table 15, a mounting mechanism 27 and a plurality of parts cassettes 16. According to the X-Y table 15, an X table 29 moving in the direction of the arrow X in Fig. 5 normal to a Y table 28 by a servo motor or the like is provided on the Y table 28 moving in the direction of the arrow Y in Fig. 5 along the depth direction of the mounting apparatus by a servo motor or the like. Furthermore, a rail 30 for retaining the print circuit board 14 is mounted on the X table 29.

The mounting mechanism 27 is composed of a mounting head 31, a driving means 32 and a positioning unit 26 as shown in Fig. 6. The construction of the mounting head 31 is shown in the enlarged view of Fig. 7.

The mounting chucks 19a through 19c are fitted in shape, respectively, to the mounting units, being different in shape. A plurality of different mounting chucks 19a through 19c are mounted movably up and down on the mounting head 18 and are normally urged upwardly by a spring 33. Also, the mounting heads 18 are adapted to pivot around the supporting shafts 23 and are located in positions divided at equal intervals on the turntable 17.

The adsorption of the adhesion portions of mounting chucks 19a through 19c is performed because of vacuum caused in holes formed in the mounting chucks 19a through 19c through the mounting head 18 by way of the hole of the supporting shaft 23, a hole being extended through a turntable 17 sealed by an O ring 35 from the bearing 34.

In a driving unit 32 shown in Fig. 7, the turntable 17 is supported by a bearing 34 mounted on a base 36, which has a turntable 17 externally secured thereto, and is coupled to an index unit 37. The index unit 37 performs its indexing operation so that the turntable 17 rotates. Also, a pusher 39 guided by a bearing 38 is disposed on the base 36 so that the mounting chucks 19a through 19c may fall at the stations in the positions of (D) through (F) of Fig. 5 for absorbing, positioning and engaging the mounting parts. The pusher 39 is vertically moved by an air cylinder 42 through a cam follower 40 and a lever 41 and hits the mounting chucks 19a through 19c to cause them to fall.

Here, a selection mechanism of the mounting chucks 19a through 19c will be described with reference to Fig. 8.

For instance, a mounting chuck 19a selected in the previous condition completes the mounting operation of the electronic parts on the print circuit board at the position of (A) and a cam follower 22 mounted on the mounting head 18 comes into contact against a fixed origin return cam 20c while the turntable 17 indexes as far as the positions of (F) and (G). The mounting chuck moves like an arrow a to pivot and return the mounting head 18 to the origin, i.e., the condition of (G). During the indexing operation from (G) to (D), a mounting chuck selection cam 20a is set in advance by a servo motor or an air cylinder 44, which is adapted to drive by data showing the types of the electronic parts, to be kept retaining in a given position. A cam follower 22 of the mounting head 18 hits the mounting chuck selection cam 20a to pivot cam

follower 22 like an arrow b along the mounting chuck selection cam 20a so that the mounting chuck 19a of the mounting head 18 is selected. A pin 46 which slides in a bearing block 45 shown by Fig. 7 is urged by a compression spring 47 and the selected mounting chuck 19a enters a hole machined in the mounting head 18 to retain the selected mounting chuck 19a. Then, a positioning mechanism in the mounting direction of the mounting chucks 19a through 19c (19a in this example) is shown. As shown in Fig. 7, a pinion gear 48 is mounted on the top of the mounting chuck 19 to interlock with a sector gear 49. The sector gear 49 rotates around a supporting point shaft 23 to rotate the mounting chuck 19. Then, a selection mechanism in the mounting direction of the mounting chuck 19 will be shown in Fig. 9. When the polarity of the electronic parts is opposite in the position of (D), the sector gear 25 drives a polarity selection cam 20d, if necessary, by an air cylinder 50 or the like to lower the mounting chucks 19a through 19c, rotating them by 180° thereby absorbing the electronic parts 21 from the parts cassettes 16 and rising to vary the polarity. Also, after the sector gear 25 has completed the positioning of the mounting parts at (E), a mounting direction selection cam 20b is set in advance by a servo motor or an air cylinder 51 to be driven with data showing the shape of the electronic parts while the turntable 17 indexes and is kept in a given position. A cam follower 24 mounted on the sector gear 25 hits the mounting direction selection cam 20b and is rotated along the mounting direction selection cam 20b to rotate a pinion gear 48 to determine the mounting direction of the mounting chucks 19a through 19c. After the mounting parts have been engaged at (F), the cam follower 22 of the sector gear 25 hits the sector gear 25 which in turn hits the origin return cam 20c as shown in Fig. 8 during the indexing operation to (F) through (G) to rotate and return the sector gear 25 to the origin, i.e., the condition of (G), this portion being not shown in Fig. 9.

The positioning unit 26 will be shown in detail hereinafter in Fig. 10. Referring to Fig. 10, the air cylinders 54 and 55 drive shafts 56 and 57 to move an X direction positioning block 58a and a Y direction positioning block 59a secured onto shafts 56 and 57. Also, a lever 60 is coupled to the tip ends of the shafts 56 and 57. The lever 60 oscillates to move shafts 61 and 62 and, then, moves an X direction positioning block 58b secured to the shaft 62, a Y direction positioning block 59b secured to the shaft 61 to position the blocks 58a, 59a and the electronic parts 21. But when the knob shape of the positioning blocks 58a, 58b, 59a and 59b is tried to be put into common use, independently of the size of the mounting parts, unstable positioning operation is performed. For example, apply the knob shape of the small mounting parts 21 of Fig. 11(A) to the large mounting parts 21 of Fig. 11(B), and the knob becomes so narrow that the positioning operation becomes difficult. Therefore, the large mounting parts are required to be made wider in shape as in Fig. 11(C). Thus, the knob portion of the positioning block is made staircase in shape as shown in Fig. 12 so that the small mounting parts may be held in a lower position as shown in Fig. 12(A) and the large mounting parts may be held in an upper position as shown in Fig. 12(B).

The upper, lower selection is performed by an air cylinder 63 shown in Fig. 10. The air cylinder 63 is coupled to a lever 64 and stops the oscillation of the cam 41 to be driven by the cylinder 63 so that the pushing amount of the mounting chucks 19a through 19c of a pusher 39 is varied to perform the upper, lower selection.

Then, a plurality of parts cassettes 16 of Fig. 5 respectively retain the various electronic parts 21 so that the moving selection is adapted to be made in the direction of Z by a servo motor or the like. The parts cassette 16 will be described with reference to Fig. 13 through Fig. 15. Immediately before the mounting chuck 19a falls, a feed lever 65 moves in the direction of Y1, as shown in Fig. 13, kicks a feed lever 66 of the parts cassettes 16, a shutter 68 holding an electronic parts through the inversion lever 67 opens in the direction of Y2 so that the mounting chuck 19a absorbs an electronic parts to raise it as shown in Fig. 14. Then, through the returning of the feed lever 65, the feed lever 66 rotates a feed ratchet 73 through the urging force of a spring 69 by a pawl 72 and a ratchet lever 71 interlocked with the feed lever 65 by a roller 70, thereby to feed ground paper tape 3 by a hook pawl 74 secured onto the feed ratchet. On the other hand, the adhesive tape 4 is adapted to be torn in the direction opposite to the feed of the ground paper from the position of the slit M because of the urging force of the spring 75 and to be wound up on a take-up reel 76. A ratchet 77, a ratchet lever 78, a ratchet 79, a joint 80 and an oscillation lever 81 are coupled to the feed lever 66 through a roller 82 as means for rotating the take-up reel 76.

An automatic apparatus for mounting electronic parts, in accordance with the present invention, constructed as described hereinabove has the following effects and is considered to be extensively used in the future in the circles. Accordingly, the industry property is great.

(1) Mounting chucks which are fitted to the shapes of the electronic parts can be equipped with, and the mounting operation thereof is high in reliability. Also, one unit allows an increase in types corresponding to different electronic parts, and the arrangement is superior in efficiency.

(2) The mounting chucks allow the vertical movement only. As the positioning operation requires only holding and the directioning operation is provided during the indexing operation, the mounting operation can be divided and the mounting speed can be improved, and the apparatus is higher in productivity.

(3) A plurality of mounting chucks are loaded. However, as the mounting head is pivotably selected so that the absorbing, positioning and mounting operations of the mounting chuck may be performed at one location, as one positioning unit will do. Also, the parts cassettes are provided as unit. Therefore, the electronic-parts feeding, ground-paper tape delivering and adhesive-tape tearing off operations can be easily performed.

## Claims

1. An automatic apparatus for mounting electronic parts (21), on printed circuit boards (14), comprising an X-Y table (15) for positioning a printed circuit board (14), a plurality of parts cassettes (16) disposed near the X-Y table (15), a turntable (17) disposed between said parts cassettes (16) and said X-Y table (15), a plurality of mounting heads (18) mounted in positions divided into equal intervals on the turntable (17), a plurality of mounting chucks (19) disposed on each of said mounting heads (18), said mounting chucks (19) picking up the electronic parts (21); an operation of mounting the electronic parts (21) on said printed circuit board (14) being sequentially repeated during the stopping of said turntable (17);
characterized in that
(a) the parts cassettes (16) are adapted to move in the lateral direction,
(b) the mounting chucks (19) are different in shape, fitted to the shape of the electronic parts,
(c) the mounting chucks (19) are disposed for pivoting and vertically moving operations on the mounting heads (18),
(d) a cam (20a) disposed near the turntable (17) selects one of a plurality of mounting chucks (19), and
(e) the turntable (17) selects the mounting direction of the electronic parts (21).

2. Apparatus as claimed in claim 1,
wherein a first cam (20a) selects one mounting chuck (19) provided on each of said mounting heads (18), the selected mounting chuck (19) picks up a given electronic parts (21), and a second cam (20b) rotates said selected mounting chuck (19) to determine the mounting direction of said electronic part (21).

3. Apparatus as claimed in claim 2,
characterized by a third cam (20d) for determining the polarity position of the electronic part (21) in a second positioning step.

4. Apparatus as claimed in claim 3,
characterized by a fourth cam (20c) for returning the mounting chucks (19) to their original positions.

5. Apparatus as claimed in any preceeding claim, wherein the mounting head (18) has a lever (22) to be rotated by a supporting shaft (23), the first cam (20a) being disposed near said turntable (17) depressing said lever to select said mounting chuck (19).

6. Apparatus as claimed in any preceeding claim, wherein to perform an operation of taking out electronic parts (21) from said parts cassettes (16) and an operation of mounting the electronic parts (21) on said printed circuit board (14), a pusher (39) opposite to the top of said turntable (17) and a depresing mechanism (40-42) for moving the pusher (39) are provided to allow said mounting chuck (19) to be vertically operated.

7. Apparatus as claimed in any preceeding claim, wherein two cams (20b, 20d) mounted near said turntable (17) depress a cam follower (24) eccentrically mounted on a sector gear (25) rotatably provided on said supporting shaft (23) by the selection of two air cylinders (50, 51) for moving said cams (20b, 20d) respectively to come into contact against said sector gear (25), and rotates a pinion (48) secured to the top end of said mounting chuck (19) so that the mounting direction of the electronic parts (21) is selected in two steps during the rotation of said turntable (17) to perform the free selection.

## Patentansprüche

1. Vorrichtung zum automatischen Montieren von elektronischen Bauteilen (21) auf gedruckten Schaltungsplatinen (14);
mit einem X-Y-Tisch (15) zum Positionieren einer Schaltungsplatine (14);
mit einer Mehrzahl von Bauteilkassetten (16) in der Nähe des X-Y-Tisches (15);
mit einem zwischen den Bauteilkassetten (16) und dem X-Y-Tisch (15) angeordneten Drehtisch (17);

mit einer Mehrzahl von Bestückungsköpfen (18), die in gleichen Abständen auf dem Drehtisch (17) angeordnet sind;

mit einer Mehrzahl von Greifern (19) an je einem der Bestückungsköpfe (18) zum Aufnehmen und Halten der elektronischen Bauteile (21);

wobei das Montieren der elektronischen Bauteile (21) auf der gedruckten Schaltungsplatine (14) sequentiell während des Stillstandes des Drehtisches (17) wiederholt wird;

dadurch gekennzeichnet, daß

(a) die Bauteilkassetten (16) zur Bewegung in lateraler Richtung ausgebildet sind,

(b) die Greifer (19) verschiedene Formen aufweisen und an die Form der elektronischen Bauteile angepaßt sind,

(c) die Greifer (19) auf den Bestückungsköpfen (18) drehbar und vertikal bewegbar angeordnet sind,

(d) in der Nähe des Drehtisches (17) ein Nocken (20a) angeordnet ist und eine aus einer Mehrzahl von Greifern (19) auswählt; und

(e) der Drehtisch (17) die Montagerichtung der elektronischen Bauteile (21) auswählt.

2. Vorrichtung nach Anspruch 1,
dadurch gekennzeichnet, daß
ein erster Nocken (20a) einen der Greifer (19) auswählt, die an dem Bestückungskopf (18) angeordnet sind,
daß der ausgewählte Greifer (19) ein bestimmtes elektronisches Bauteil (21) aufnimmt und
daß ein zweiter Nocken (20b) den ausgewählten Greifer (19) zur Festlegung der Montagerichtung des elektronischen Bauteils (20) rotiert.

3. Vorrichtung nach Anspruch 2,
gekennzeichnet durch einen dritten Nocken (20d) zum Festlegen der Polaritätsposition des elektronischen Bauteils (21) in einem zweiten Positionierungsschritt.

4. Vorrichtung nach Anspruch 3,
gekennzeichnet durch einen vierten Nocken (20c) zum Wiedereinstellen der Greifer (19) in die ursprüngliche Position.

5. Vorrichtung nach einem der vorstehenden Ansprüche,
dadurch gekennzeichnet, daß
der Bestückungskopf (18) einen durch eine Tragwelle (23) drehbaren Hebel (22) aufweist und
daß der erste Nocken (20a) in der Nähe des Drehtisches (17) angeordnet ist und den Hebel zur Auswahl des Greifers (19) niederdrückt.

6. Vorrichtung nach einem der vorstehenden Ansprüche,
dadurch gekennzeichnet, daß zum Herausnehmen von elektronischen Bauteilen (21) aus den Bauteilkassetten (16) und zum Montieren der elektronischen Bauteile (21) auf der Schaltungsplatine (14) ein Stößel (39) gegenüber der Oberseite des Drehtisches (17) und Niederdrückmechanismus (40-42) zum Bewegen des Stößels (39) vorgesehen sind, damit der Greifer (19) in Vertikalrichtung betätigt werden kann.

7. Vorrichtung nach einem der vorstehenden Ansprüche,
dadurch gekennzeichnet, daß
zwei in der Nähe des Drehtisches (17) angeordnete Nocken (20b, 20d) ein Nockenfolgeglied (24) niederdrücken, das exzentrisch an einem Zahnradsektor (25) angeordnet ist, der an der Tragwelle (23) zwecks Rotation befestigt ist;
daß die beiden Nocken (20b, 20d) zur Auswahl durch zwei Luftzylinder (50, 51) in Kontakt mit dem Zahnradsektor (25) gebracht werden; und
daß hierdurch ein am oberen Ende des Greifers (19) befestigtes Zahnrad (48) in Rotation versetzt wird, so daß die Montagerichtung der elektronischen Bauteile (21) in zwei Schritten während der Rotation des Drehtisches (17) frei ausgewählt wird.

**Revendications**

1. Appareil automatique de montage de composants électroniques (21) sur des cartes (14) de circuit imprimé, comprenant une table X-Y (15) destinée à positionner une carte (14) de circuit imprimé, plusieurs cassettes (16) de composants, disposées à proximité de la table X-Y (15), un plateau tournant (17) disposé entre les cassettes (16) et la table X-Y (15), plusieurs têtes de montage (18) qui sont montées à des positions séparées par des intervalles égaux sur le plateau tournant (17), plusieurs mandrins (19) de montage disposés sur chaque tête de montage (18), les mandrins de montage (19) prélevant les composants électroniques (21), une opération de montage des composants électroniques (21) sur la carte (14) de circuit imprimé étant répétée successivement pendant l'arrêt du plateau tournant (17),
    caractérisé en ce que
    (a) les cassettes (16) de composants sont destinées à se déplacer en direction latérale,

(b) les mandrins de montage (19) ont des configurations différentes correspondant à la configuration des composants électroniques,

(c) les mandrins de montage (19) sont disposés pour permettre des opérations de pivotement et de déplacement vertical sur les têtes de montage (18),

(d) une came (20a) disposée à proximité du plateau tournant (17) sélectionne l'un des mandrins parmi plusieurs mandrins de montage (19), et

(e) le plateau tournant (17) sélectionne le sens de montage des composants électroniques (21).

2. Appareil selon la revendication 1, dans lequel une première came (20a) sélectionne un premier mandrin de montage (19) placé sur chacune des têtes de montage (18), le mandrin sélectionné (19) prélève un composant électronique déterminé (21), et une seconde came (20b) fait tourner le mandrin sélectionné (19) afin de déterminer le sens de montage du composant électronique (21).

3. Appareil selon la revendication 2, caractérisé par une troisième came (20d) destinée à déterminer la position du composant électronique (21) en fonction de sa polarité dans une seconde étape de positionnement.

4. Appareil selon la revendication 3, caractérisé par une quatrième came (20c) destinée à ramener les mandrins de montage (19) à leur position initiale.

5. Appareil selon l'une quelconque des revendications précédentes, dans lequel la tête de montage (18) possède un levier (22) destiné à être entraîné en rotation par un arbre de support (23), la première came (20a) étant placée à proximité du plateau tournant (17) et repoussant le levier afin qu'elle sélectionne le mandrin de montage (19).

6. Appareil selon l'une quelconque des revendications précédentes, dans lequel, lors de l'exécution d'une opération d'extraction de composants électroniques (21) des cassettes (16) et d'une opération de montage des composants électroniques (21) sur la carte (14) de circuit imprimé, un poussoir (39) placé en face de la partie supérieure du plateau tournant (17) et un mécanisme d'enfoncement (40-42) destiné à déplacer le poussoir (39) sont disposés afin qu'ils permettent un fonctionnement vertical du mandrin de montage (19).

7. Appareil selon l'une quelconque des revendications précédentes, dans lequel deux cames (20b, 20d) montées près du plateau tournant (17) repoussent un toucheau (24) de came monté excentriquement sur un secteur denté (25) placé afin qu'il puisse tourner sur l'arbre de support (23) par sélection de deux vérins pneumatiques (50, 51) destinés à déplacer les cames (20b, 20d) afin qu'elles viennent au contact du secteur denté (25) et fassent tourner un pignon (48) fixé à l'extrémité supérieure du mandrin de montage (19) et que le sens de montage des composants électroniques (21) soit sélectionné en deux étapes pendant la rotation du plateau tournant (17) et puisse être sélectionné librement.

Fig. 1

(A)          (B)          (C)          (D)

Ia           Ib           Ic           Id

Fig. 3
PRIOR ART

Z

5

6  7

9

8

10

X

Y

*Fig. 2*

*Fig. 4 PRIOR ART*

EP 0 155 512 B1

Fig. 5

Fig. 8

11

Fig. 6

EP 0 155 512 B1

Fig. 7

EP 0 155 512 B1

Fig. 10

Fig. 9

14

Fig. 11

(A)

58b   59b   58a

59a   21

(B)

58b   59b   58a

59a   21

(C)

58b   59b   58a

21   59a

Fig. 12

(A)

58b   19   58a

21

(B)

19   21

58b   58a

Fig. 13

Fig. 14

Fig. 15